# FASCICULE DE BREVET EUROPEEN

(11) **EP 0 443 920 B1**
(45) Date de publication et mention de la délivrance du brevet: **02.11.1994**
(21) Numéro de dépôt: 91400395.9
(22) Date de dépôt: 15.02.1991
(51) Int. Cl.: C30B 11/12, C30B 29/62, H01J 9/02

(54) **Procédé de croissance controlée de cristaux aciculaires, et application à la réalisation de microcathodes à pointes**
Verfahren zur gesteuerten Züchtung von nadelförmigen Kristallen und ihre Verwendung zur Herstellung spitzenförmiger Mikrokathoden
Process for the controlled growth of needle-like crystals and their application for making pointed microcathodes

(30) Priorité: 23.02.1990 FR 9002258
(43) Date de publication de la demande: 28.08.1991
(73) Titulaire: THOMSON-CSF, 75008 Paris (FR)
(72) Inventeur: Pribat, Didier, F-92045 Paris la Défense (FR); Leclerc, Pierre, F-92045 Paris la Défense (FR); Legagneux, Pierre, F-92045 Paris la Défense (FR); Collet, Christian, F-92045 Paris la Défense (FR)
(74) Mandataire: Guérin, Michel

(56) Documents cités:
- EP-A- 0 278 405
- WO-A-89/09479
- US-A- 3 493 431
- APPLIED PHYSICS LETTERS, vol. 4, no. 5, mars 1964, pages 89-90; R.S. WAGNER et al.: "Vapor-liquid-solid mechanism of single crystal growth"
- IBM TECHNICAL DISCLOSURE BULLETIN, vol. 19, no. 10, mars 1977, page 4045, New York, US; W.A. THOMPSON: "Preparing high emission cathodes"

## Description

L'invention concerne un procédé de croissance contrôlée de cristaux aciculaires et son application à la réalisation de microcathodes à pointes. Plus particulièrement l'invention a trait au domaine de la croissance contrôlée de monocristaux filamentaires de type ˝whiskers˝. Elle permet, au moyen d'une méthode connue (méthode VLS) développée dans les années soixante d'obtenir des matrices régulières de cristaux filamentaires de hauteur et diamètre contrôlés.

Une des applications possibles est la réalisation de matrices de micropointes pour cathodes à effet de champ.

Les whiskers sont des monocrocristaux filamentaires présentant un rapport de longueur au diamètre supérieur à 10. Ils sont connus depuis très longtemps, mais l'intérêt pour ce type de cristaux a été stimulé au début des années 50 lorsque Herring et Galt, dans le document Physical Review 85, (1952), 1060, ont démontré que ces cristaux possédaient des propriétés mécaniques analogues à celles des monocristaux.

E.I. GIVARGIZOV a également parfaitement illustré cette technique dans : ˝Current Topics in Materials Science˝, Volume 1, édité par E. KALDIS, North Holland, 1978, p. 79.

Deux macanismes ont été avancés pour expliquer la croissance filamentaire en phase vapeur largement anisotrope, à savoir, un mécanisme qui postule l'existence d'une dislocation vis au centre du cristal, celle-ci se comportant comme une marche atomique insaturable (croissance du cristal en hélice autour de l'axe de la dislocation) et un mécanisme VLS (pour Vapor-Liquid-Solid) qui prévoit la présence d'une phase liquide au sommet du whisker comme source essentielle d'anisotropie.

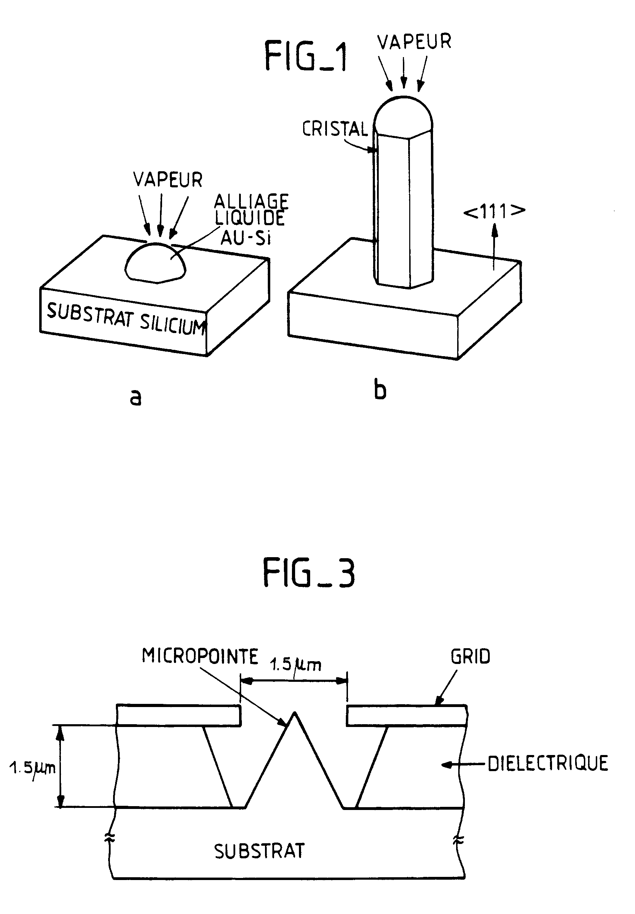

Le principe de la méthode VLS est représenté sur les figures 1a et 1b pour un substrat (111) de silicium ; on s'arrange pour intercaler entre la phase vapeur et le solide une couche de liquide dans lequel le Si est soluble. La surface de liquide présentant des sites d'adsorbtion insaturables (car il y a dissolution immédiate de l'adsorbat et renouvellement du site) en nombre très élevé (chaque atome de surface du liquide est potentiellement un site d'adsorbtion) est ainsi un lieu de dépôt privilégié à l'origine de l'anisotropie de croissance.

L'adsorbat dissout provoque une sursaturation du liquide qui expulse alors du solide à l'interface liquide/solide, de façon à revenir à l'équilibre ; la goutte de liquide s'élève petit à petit sur le cristal expulsé qui prend la forme d'un whisker de diamètre égal à celui de la goutte de liquide.

Les figures 1a et 1b représentent le principe VLS appliqué au silicium, mais il est bien évident que l'on peut utiliser toute une variété de substrats différents associés à des gouttes de liquide aussi très variés. (Voir par exemple GIVARGIZOV déjà cité).

Selon les techniques connues on peut donc faire croître sur un substrat des monocristaux filamentaires. Cependant, cette croissance n'est pas contrôlée et les points de croissance sont situés de façon aléatoire et irrégulière sur la surface du substrat.

La présente invention concerne un procédé de croissance contrôlée de monocristaux filamentaires (whiskers) utilisant la méthode VLS. En contrôlant cette croissance, l'invention permet donc de réaliser des monocristaux filamentaires en des points choisis de la surface du substrat et de réaliser par exemple des matrices de filaments.

L'invention concerne un procédé de croissance contrôlée de cristaux aciculaires caractérisé en ce qu'il comporte les étapes suivantes:
- une première étape de réalisation sur un substrat d'une première couche d'un matériau sur lequel il ne pourra y avoir ni croissance, ni nucléation du matériau à faire croître dans les étapes ultérieures ;
- une deuxième étape de réalisation dans ladite première couche d'au moins une ouverture ;
- une troisième étape de dépôt dans ladite ouverture d'au moins un matériau dans lequel peut se dissoudre le matériau de la phase vapeur (matériau à faire croître) et à partir de ladite goutte ;
- une quatrième étape de chauffage de fusion du matériau de la troisième étape et de croissance en phase vapeur, dans ladite ouverture, du matériau à faire croître sous la forme d'un cristal filamentaire.

L'invention concerne également un procédé de réalisation d'une microcathode à pointes appliquant le procédé précédent caractérisé en ce qu'il comporte avant la deuxième étape de réalisation, une phase de réalisation d'une troisième couche d'un matériau conducteur de l'électricité suivie d'une autre phase de réalisation d'une quatrième couche d'un matériau diélectrique servant de couche de passivation.

Les différents objets et caractéristiques de l'invention apparaîtront plus clairement dans la description qui va suivre et dans les figures annexées qui représentent :
- les figures 1a et 1b, une technique de croissance connue déjà décrite précédemment ;
- les figures 2a à 2 g, un procédé de croissance de monocristaux selon l'invention ;
- la figure 3, une électrode à pointe obtenue par le procédé de l'invention ;
- les figures 4a à 4c, un procédé de réalisation d'une cathode à micropointes selon l'invention ;
- la figure 5, une vue détaillée d'une électrode à pointe obtenue par le procédé des figures 4a à 4e ;
- les figures 6a à 6d, une variante du procédé de réalisation selon l'invention ;
- les figures 7a à 7d, une autre variante du procédé de réalisation selon l'invention.

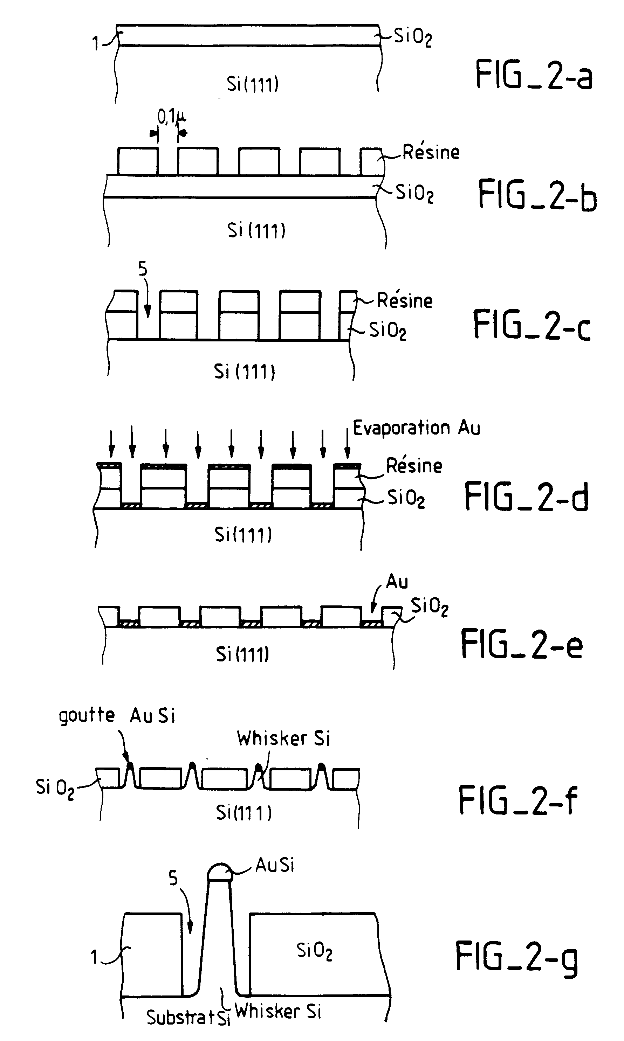

En se reportant aux figures 2a à 2g on va tout d'abord décrire le procédé de base selon l'invention.

On utilise comme cela est représenté en figure 2a un substrat de Si par exemple ou de GaAs, d'orientation de préférence (111) sur lequel on dépose (ou on obtient par oxydation) une couche 1 de SiO₂ d'épaisseur typiquement comprise entre 0,1 micromètres et quelques micromètres.

On dépose ensuite une couche de résine photosensible (ou un masque superficiel métallique) que l'on insole et développe (optiquement ou à l'aide d'un faisceau d'électrons) de façon à réaliser des ouvertures 5 sensiblement circulaires de diamètre compris entre 0,1 et 2 µm au pas de 0,5 à quelques microns. On obtient ainsi une structure telle que représentée en figure 2b.

On grave ensuite (figure 2c) par RIE (Reactive Ion Etching) la silice sous-jacente en utilisant le masque de résine (ou le masque métallique selon le cas).

On dépose ensuite (figure 2d) par évaporation une couche de métal tel que de l'or (ou bien d'Ag, Cu, Pt, Pd, Ni, Gd, Mg, Os, ...) d'épaisseur de 1 nm à 500 nm, qui sera adaptée au diamètre des ouvertures dans SiO₂ (plus le diamètre des ouvertures sera faible, plus l'épaisseur de la couche de métal sera elle aussi faible).

On dissout (figure 2e) ensuite la résine ou bien le masque métallique (dans ce dernier cas on opère une dissolution électrochimique) de façon à éliminer la résine et le dépôt d'Au situé sur la résine précitée.

L'ensemble des étapes représentées par les figures 2d et 2e est une opération de lift off classique.

A ce stade du procédé on a obtenu des points métalliques (d'or par exemple) localisés avec précision. Par exemple on a pu obtenir une matrice de points d'or.

Au cours de l'étape suivante on procède à la croissance d'un matériau semi-conducteur ou autre sur les points de métal sélectivement déposés précédemment ; pour celà, et toujours selon l'exemple du silicium on introduit le substrat ainsi obtenu dans un réacteur de dépôt CVD en atmosphère SiH₄ + HCl ou SiH₂Cl₂ + HCl ou SiCl₄, ou encore SiHCl₃ + HCl (toujours utilisant comme gaz porteur H₂) et on porte la température entre typiquement 400 et 1000° C.

Dans ces conditions, on obtient la formation d'une phase liquide (AuSi, AuP, AuCu...) de type entectique ou non dans chaque micrologement de SiO₂.

Ainsi que précédemment expliqué, on a une adsorption préférentielle des molécules de la phase gazeuse sur les gouttelettes de liquide, ce qui induit une anisotropie de croissance locale.

On utilise typiquement un mélange gazeux composé de SiH₄ et de HCl afin d'obtenir une sélectivité de dépôt et éviter la nucléation du silicium sur la silice comme cela a été décrit par exemple dans les documents suivants :
- J.O. BORLAND, C.I. DROWLEY
   Solid State Technology Août 1985 p. 141
- L. KARAPIPERIS et Coll
   Proceeding of the 18th Int. Conf. on Solid State Devices and Materials TOKYO 1986, p. 713.

De cette manière, on est certain de n'avoir de dépôt qu'au niveau des gouttelettes de liquide permettant la croissance des whiskers (figure 2 f). La figure 2g représente de façon plus détaillée une telle croissance.

On obtient ainsi des réseaux réguliers bidimentionnels de whiskers.

Notamment, si on a réalisé les dépôts de métal sous forme d'une matrice, on peut obtenir une matrice de monocristaux filamentaires (whiskers).

Une des applications possibles est la réalisation de réseaux de microcathodes à effet de champ ; les dimensions typiques d'une telle microcathode sont les suivantes :
- dimensions à la base = 1,5 µm
- hauteur = 1,5 µm

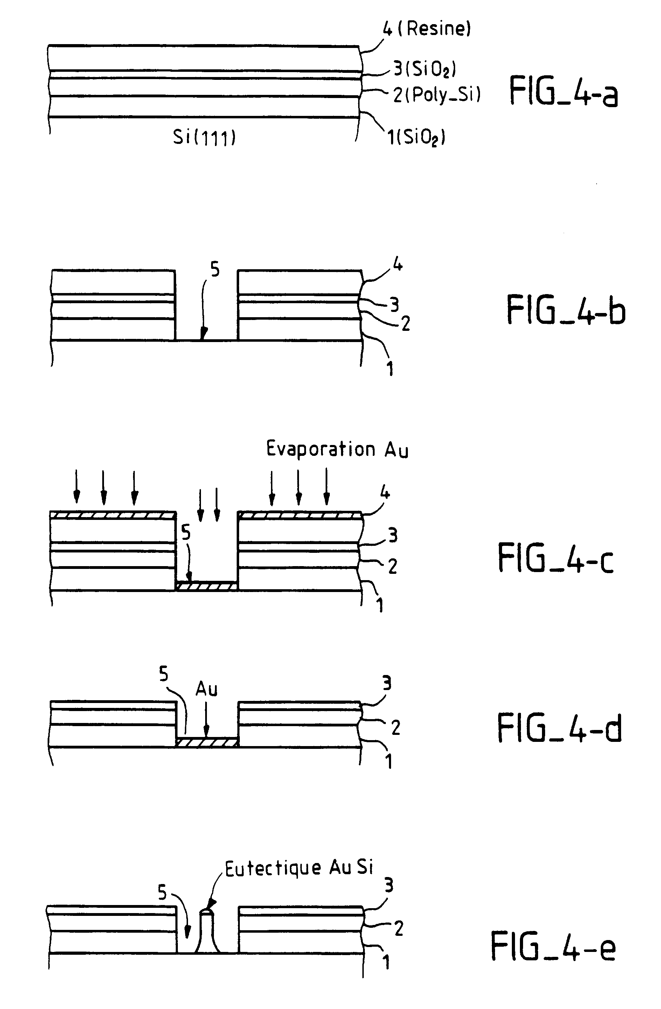

Une telle microcathode a des caractéristiques électriques suivantes :
émission de champ pour E = 30 x 10⁶ V/cm environ,
tension de grille = 50V < V_{G} < 300 V
courant de pointe = 0,1µA < Ip < 100 µA
densité de pointes = 10⁶/cm²
En se reportant aux figures 4a à 4e on va maintenant décrire un procédé de réalisation de microcathodes à pointes utilisant le procédé de croissance précédent. Le procédé qui va suivre permet la fabrication autoalignée de réseaux de microcathodes à base de whiskers.

On part d'une structure composite représentée en figure 4a et constituée d'un substrat à base de Si(111) typiquement recouvert de couches suivantes :
- couche 1 de SiO₂ ou diélectrique de grille (épaisseur de 1 à 10 µm),
- couche 2 de grille métallique (ou en silicium polycristallin dégénéré) d'épaisseur 0,1 à 1 µm (G).
- couche 3 de passivation ;

La grille est passivée à l'aide d'une couche 3 de SiO₂ ou Si₃N₄ très mince, de façon à éviter la nucléation sur cette dernière pendant l'opération ultérieure de dépôt ; on dépose sur l'ensemble une couche 4 de résine.

Après insolation, révélation et développement de la résine, on grave par RIE comme cela est représenté en figure 4b, des ouvertures telles que 5 dans la structure composite préalablement obtenue. Ces ouvertures sont typiquement circulaires et ont un diamètre compris entre 0,1 et 2 micromètres par exemple.

Le pas de ces ouvertures peut être de 0,5 micromètres à quelques micromètres.

On réalise ensuite (figure 4c) une opération de dépôt métallique (de l'or par exemple) sur l'ensemble de la structure puis on pratique une opération de ˝lift-off˝ (figure 4d) de façon à enlever la couche 4 de résine et le métal qui se trouve sur cette couche.

On fait ensuite croître (figure 4e) des whiskers tels que 6 à partir des zones métallisées fondues (telles que la zone 5) de la même façon que cela a été décrit précédemment.

Si l'on fait varier la température pendant l'étape de dépôt, on peut obtenir une variation de diamètre des whiskers. Ainsi la diminution de la température entraîne une diminution de ce diamètre.

Cette décroissance du diamètre peut permettre d'obtenir des micropointes très acérées tout simplement par un traitement contrôlé d'oxydation après dépôt. En effet, l'oxydation étant un processus isotrope, on transformera progressivement le silicium en SiO₂ à partir de la partie sommitale des whiskers et l'interface Si/SiO₂ gardera nécessairement la forme d'une pointe. Il suffira ensuite d'éliminer la silice formée par oxydation pour révéler les micropointes en Si.

On peut aussi pendant l'étape de dépôt opérer un dopage des whiskers, en adjoignant au mélange SiH₄ + H Cl de l'arsinic (AsH₃), de la phosphine (PH₃) etc. pour un dopage de type n ou bien du diborane (B₂H₆) pour un dopage de type p.

On peut ainsi réaliser des jonctions n-p pendant la croissance.

Dans ce qui précède, on a considéré la formation d'alliages Me-Si où Me est un métal très peu soluble (solubilité de l'ordre de 10¹⁵ à 10¹⁷ at/cm³ dans le silicium ou dans le GaAs et d'une façon générale dans le matériau constitutif du substrat).

On peut cependant utiliser un alliage (par exemple Sb - Si, As - Si, Ga - Si, Al - Si...) dans lequel le métal ou le semi-métal (Al, Ga, As, Sb...) déposé dans les zones de croissance des whiskers et constitutif de l'alliage est très soluble dans le silicium (ou dans GaAs ou dans le substrat) avec une solubilité supérieure typiquement à 10¹⁹ at/cm³. (Pour As par exemple la solubilité maximale à 1 000° C dans Si est de 1,8 10²¹/cm³).

Dans ces conditions, on aura au fur et à mesure de la croissance des whiskers une diminution appréciable de la taille de la gouttelette. Cette diminution de taille est due à une incorporation significative dans le whisker en croissance de l'élément d'alliage du Si ; ceci se traduira par une diminution corrélative du diamètre de la goutte d'alliage et les whiskers auront ainsi naturellement la forme de micropointes. Le processus de croissance se terminera de lui-même lorsque tout l'élément d'alliage aura été incorporé dans chaque whisker.

A titre d'exemple non limitatif, si l'on veut faire pousser une matrice de microcathodes à base de whiskers en Si de longueur 5 µm, on déposera dans les cavités (figures 4c et 4d) de SiO₂ de l'ordre de 0,03 µm de gallium. (Les densités atomiques du Si et de Ga sont voisines et de l'ordre de 5.10 ²² At/cm³ et la (solubilité maximale à 1000°C de Ga dans Si et de l'ordre de 3 10¹⁹/cm³). Dans ce cas, la croissance s'arrêtera d'elle-même lorsque tout l'élément d'alliage aura été consommé, (le Ga en l'occurrence) c'est-à-dire compte tenu de la solubilité précitée du Ga dans Si, lorsque les whiskers auront atteint une hauteur de 5 µm.

Un autre exemple concerne l'utilisation d'un substrat de GaAs. Dans ce cas, on disposera, dans les micrologements, du gallium et on opérera sous flux de AsH₃ ou de As₂ ou As₄. On obtiendra par suite une croissance de GaAs qui s'arrêtera d'elle-même lorsque le gallium de la goutte aura été incorporé dans le cristal.

Ces différents exemples ne sont pas limitatifs et servent simplement à illustrer le principe de l'incorporation progressive de l'un des éléments d'alliage formant la microgoutte liquide, ce qui amène corrélativement à l'auto-façonnage des micropointes.

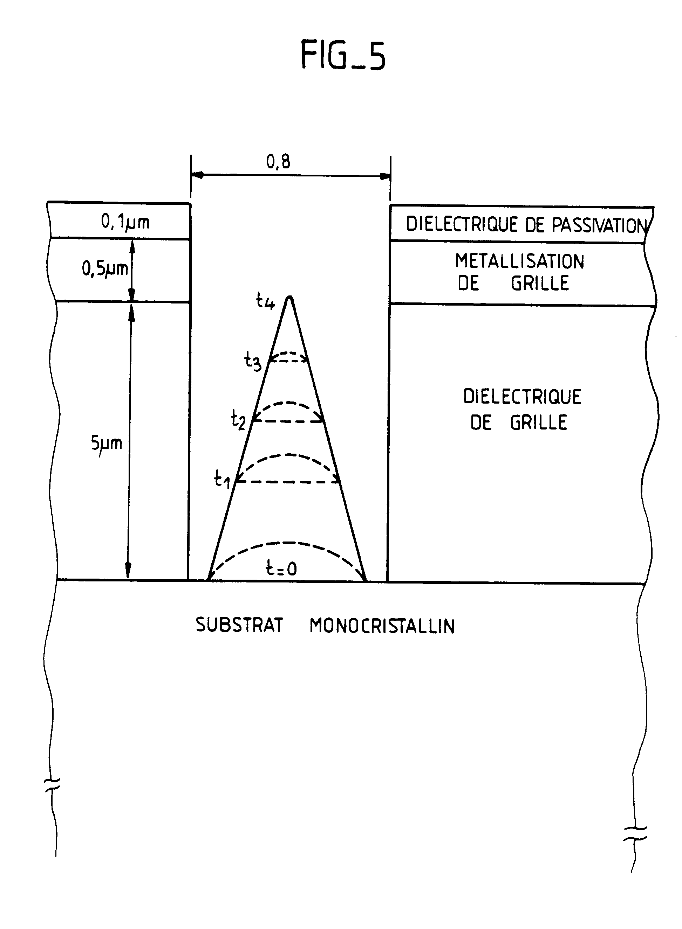

La figure 5 résume ce principe en montrant à différents temps ti,(ti + 1>ti) la morphologie de la gouttelette et du cristal sous-jacent. Au fur et à mesure que le temps croît, la taille de la gouttelette diminue, ce qui conduit à un façonnage de la micropointe. Différents paramètres géométriques sont précisés à titre indicatif sur la figure 5.

Le procédé a été expliqué en se référant à des alliages binaires ; il est bien évident que l'on pourrait utiliser des ternaires (AsGaSi par exemple) ou des quaternaires.

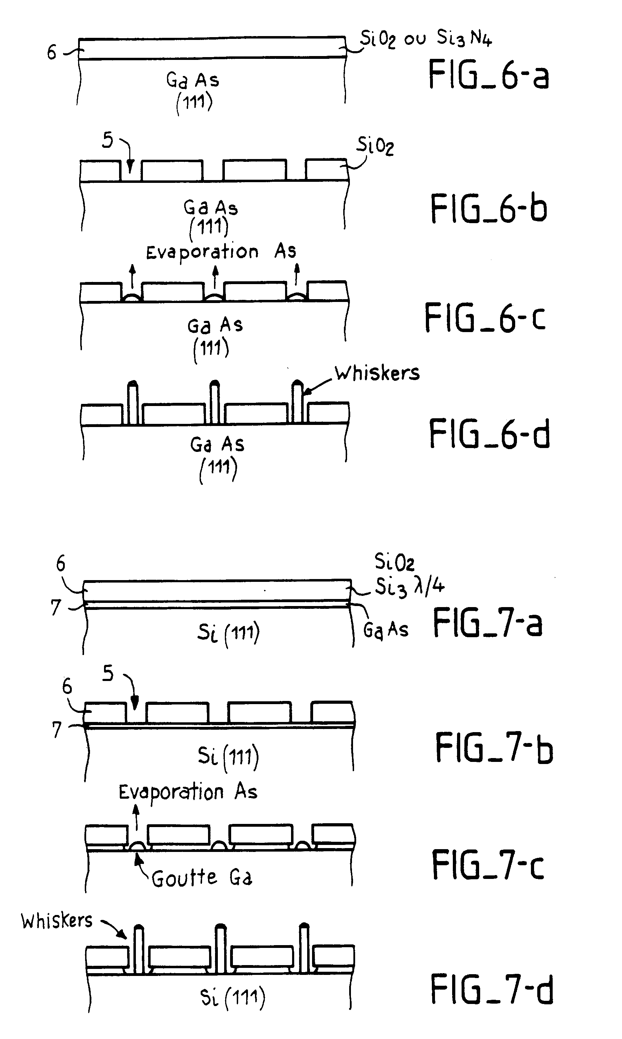

Une autre méthode de formation de microgouttes localisées peut aussi être mise en pratique en utilisant un substrat de départ de Ga As sur lequel on dépose tout d'abord une couche 16 de SiO₂ ou de Si₃N₄ (figure 6a) d'épaisseur comprise entre 0,1 et 10 µm typiquement. On grave dans cette couche de diélectrique des micrologements 5 (figure 6b) de même que lors du procédé précédent. On chauffe ensuite de manière contrôlée (dans une enceinte étanche évacuée ou balayée) le substrat de Ga As, ce qui a pour effet de faire évaporer de l'arsenic et donc de faire apparaître des gouttelettes de Ga localisées à l'endroit où a lieu l'évaporation préférentielle c'est-à-dire dans les micrologements 5. Il y a donc un autoalignement des gouttelettes avec les logements de diélectrique (figure 6c). On fait ensuite entrer un mélange gazeux de croissance type GaCl + As₄ obtenu par exemple dans un réacteur VPE par la méthode au trichlorure d'arsenic (AsCl₃) ou bien un mélange tel que AsH₃ + TMG (trimethyl gallium) ou TEG (triethyl gallium) de façon à obtenir la croissance de whiskers de GaAs (figure 6d). Il va sans dire que l'on peut obtenir des whiskers formés d'empilement de GaAs, GaAlAs etc., en utilisant les gaz générateurs appropriés.

Les figures 7a à 7 d représentent une variante de ce procédé.

Selon ce procédé donné à titre d'exemple on dépose sur un substrat de silicium une couche 7 de GaAs.

La couche 7 est ensuite recouverte d'une couche 16 de SiO₂ ou de Si₃N₄ (figure 7a).

Comme précédemment, on réalise dans la couche 16 des ouvertures 5 (figure 7b).

Ensuite, on chauffe l'ensemble à une température telle qu'il y ait évaporation de l'arsenic de la couche de GaAs qui se trouve découverte dans les ouvertures 5. Il reste, donc dans chaque ouverture 5, une goutte de gallium (figure 5c). On fait ensuite, comme cela est représenté en figure 7d, une croissance de whiskers à l'aide d'un gaz tel que SiH₄ pour whiskers en Si ou les gaz précités (GaCl + As₂ ou TMG, TEG + AsH₃ pour obtenir une croissance de whiskers GaAs.

Il est bien évident que dans cette méthode le substrat pourrait être un autre matériau semiconducteur que le silicium. Le point important de ce procédé est que pour réaliser la goutte de matériau permettant la croissance d'un whisker, on réalise une couche 7 d'un matériau, qui par évaporation, fournit dans chaque ouverture 5, un constituant liquide susceptible d'absorber le ou les constituants (sous forme de précurseurs gazeux) du matériau à faire croître sous forme de whiskers.

Le façonnage de la forme des micropointes peut être réalisé par d'autres techniques.

Notamment selon l'invention, on peut prévoir qu'un élément de l'alliage de la goutte de liquide est légèrement volatile en chauffant. Par exemple, en cas de présence de l'arsenic dans cet alliage, on stabilisera cet arsenic par adjonction d' AsH₃ dans le flux gaz lors de la croissance.

La diminution du flux d'AsH₃ permettra une évaporation de l'arsenic de la goutte de liquide et celle-ci en diminuant de volume conduira à une diminution de la section du filament correspondant.

On peut également prévoir, dans le flux gazeux, un gaz corrosif permettant d'attaquer au moins un des éléments de l'alliage de liquide. Par exemple, dans le cas d'une goutte contenant du gallium on prévoira un gaz HCl mélangé aux gaz de croissance qui donnera, avec le gallium, du GaCl. Selon la quantité de HCl on aura une diminution correspondante de la taille de la goutte.

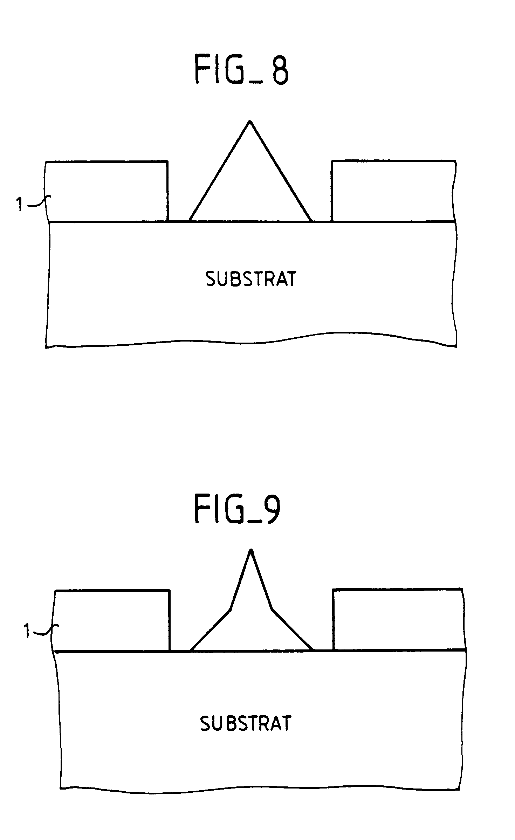

Alors que le procédé décrit précédemment en relation avec les figures 1 à 7d permet d'obtenir des micropointes de forme générale représentée en figure 8, les procédés de variation d'une goutte de liquide, tel que celui prévoyant un élément volatile dans la goutte de liquide, ou celui prévoyant un gaz corrosif dans le flux gazeux permet d'obtenir une micropointe du type par exemple représenté en figure 9. Sur cette figure 9 on voit que durant la croissance de la hauteur h de la micropointe, on a réduit rapidement la dimension de la goutte liquide.

Il ressort de ce qui précède que :
- l'invention concerne une méthode de localisation aisée et reproductible de la position de gouttes d'impuretés liquides.
- l'invention concerne une méthode de génération de gouttes ˝in situ˝.
- l'invention concerne une méthode de formation de whiskers de diamètre décroissant.

## Revendications

1. procédé de croissance contrôlée de cristaux aciculaires caractérisé en ce qu'il comporte les étapes suivantes :
- une première étape de réalisation sur un substrat d'une première couche (1) d'un matériau sur lequel il ne pourra y avoir ni croissance, ni nucléation du matériau à faire croître dans les étapes ultérieures ;
- une deuxième étape de réalisation dans ladite première couche (1) d'au moins une ouverture (5) ;
- une troisième étape de dépôt sélectif dans ladite ouverture (5) d'au moins un matériau qui une fois liquide est susceptible de se dissoudre et d'absorber le matériau à faire croître ;
- une quatrième étape de chauffage de fusion du matériau de la troisième étape et de croissance en phase vapeur, dans ladite ouverture (5), du matériau à faire croître sous la forme d'un cristal filamentaire.

2. Procédé selon la revendication 1, caractérisé en ce que la deuxième étape de réalisation d'une ouverture (5) se fait par dépôt d'un masque et attaque du matériau de ladite première couche (1) à travers le masque.

3. Procédé selon la revendication 2, caractérisé en ce que la troisième étape de dépôt se fait par évaporation dudit matériau suivi d'un enlèvement du masque et du matériau déposé à la surface du masque.

4. Procédé selon la revendication 1, caractérisé en ce que la première étape de réalisation de la première couche (1) est précédée par une phase de dépôt d'une deuxième couche d'un matériau contenant un constituant dans lequel le substrat peut se dissoudre et que la troisième étape de dépôt se fait par évaporation permettant de ne garder dans l'ouverture (5) que ledit constituant.

5. Procédé selon la revendication 1, caractérisé en ce que le substrat est du silicium et le matériau déposé lors de la troisième étape est un métal tel que Au, Cu, Pt, Pd, Ni, Gd, Mg) et que la quatrième étape se fait avec un gaz de SiH₄ et Hcl, ou SiH₂Cl₂ et HCl, ou SiCl₄.

6. Procédé selon la revendication 1, caractérisé en ce que le substrat est du GaAs et que la quatrième étape se fait avec un gaz de GaCl + As₄ ou TMG, TEG + AsH₃.

7. Procédé selon la revendication 6, caractérisé en ce que la troisième étape se fait par évaporation de l'arsenic du GaAs se trouvant dans l'ouverture de façon à former une goutte de gallium dans l'ouverture.

8. Procédé selon la revendication 1, caractérisé en ce qu'on prévoit une variation de la température lors de la quatrième étape de croissance de façon à faire varier la largeur (le diamètre) du cristal filamentaire.

9. Procédé selon l'une des revendications précédentes, caractérisé en ce que le matériau de la troisième étape contient un constituant qui est volatile à la température de croissance de la quatrième étape et que la croissance de la quatrième étape se fait en présence d'un gaz permettant de contrôler l'évaporation de ce constituant.

10. Procédé selon l'une des revendications 1 à 8 précédentes, caractérisé en ce que la croissance d'un gaz corrosif permettant d'attraquer au moins un constituant du matériau déposé lors de la troisième étape, la quantité de ce gaz corrosif étant contrôlée de façon à contrôler l'attaque de ce constituant.

11. Procédé de réalisation d'une microcathode à pointe appliquant le procédé de l'une quelconque des revendications précédentes, caractérisé en ce qu'il comporte avant la deuxième étape de réalisation, une phase de réalisation d'une troisième couche (2) d'un matériau conducteur de l'électricité suivie d'une autre phase de réalisation d'une quatrième couche (3) d'un matériau diélectrique servant de couche de passivation.

## Claims

1. Process for controlled growth of acicular crystals, characterized in that it comprises the following stages:
- a first stage for producing on a substrate a first layer (1) of a material on which there can be neither growth nor nucleation of the material to be grown in the subsequent stages;
- a second stage for producing at least one opening (5) in the said first layer (1);
- a third stage for selective deposition in the said opening (5) of at least one material which, once liquid, is capable of dissolving and of absorbing the material to be grown;
- a fourth stage for heating for melting of the material from the third stage and for vapour-phase growth, in the said opening (5) of the material to be grown in the form of a filamentary crystal.

2. Process according to Claim 1, characterized in that the second stage for producing an opening (5) is carried out by depositing a mask and etching the material of the said first layer (1) through the mask.

3. Process according to Claim 2, characterized in that the third stage for deposition is performed by evaporation of the said material followed by a removal of the mask and of the material deposited at the surface of the mask.

4. Process according to Claim 1, characterized in that the first stage for producing the first layer (1) is preceded by a stage of deposition of a second layer of a material containing a constituent in which the substrate can dissolve and that the third stage for deposition is performed by evaporation allowing only the said constituent to be kept in the opening (5).

5. Process according to Claim 1, characterized in that the substrate is silicon and the material deposited during the third stage is a metal such as Au, Cu, Pt, Pd, Ni, Gd or Mg and that the fourth stage is performed with a gas of SiH₄ and HCl, or SiH₂Cl₂ and HCl, or SiCl₄.

6. Process according to Claim 1, characterized in that the substrate is GaAs and that the fourth stage is performed with a gas of GaCl + As₄ or TMG, TEG + AsH₃.

7. Process according to Claim 6, characterized in that the third stage is performed by evaporating arsenic from the GaAs which is in the opening so as to form a drop of gallium in the opening.

8. Process according to Claim 1, characterized in that a change in temperature is provided during the fourth stage of growth so as to vary the width (the diameter) of the filamentary crystal.

9. Process according to one of the preceding claims, characterized in that the material from the third stage contains a constituent which is volatile at the temperature of growth in the fourth stage and that the growth in the fourth stage is performed in the presence of a gas allowing the evaporation of this constituent to be controlled.

10. Process according to one of the preceding Claims 1 to 8, characterized in that the growth of a corrosive gas which makes it possible to etch at least one constituent of the material deposited during the third stage, the quantity of this corrosive gas being controlled so as to control the etching of this constituent.

11. Process for producing a microcathode with a point applying the process of any one of the preceding claims, characterized in that before the second stage of production it comprises a stage for producing a third layer (2) of an electrically conductive material, followed by another stage for producing a fourth layer (3) of a dielectric material acting as a passivating layer.

## Patentansprüche

1. Verfahren zur gesteuerten Züchtung von nadelförmigen Kristallen, dadurch gekennzeichnet, daß es die folgenden Schritte aufweist:
- einen ersten Schritt der Herstellung einer ersten Schicht (1) auf einem Substrat, die aus einem Material besteht, auf dem weder eine Züchtung noch eine Nukleation des in den späteren Schritten zu züchtenden Materials vorliegen kann;
- einen zweiten Schritt der Herstellung wenigstens einer Öffnung (5) in der ersten Schicht (1);
- einen dritten Schritt der selektiven Abscheidung wenigstens eines Materials in der Öffnung (5), das sich im flüssigen Zustand lösen und das zu züchtende Material absorbieren kann;
- einen vierten Schritt der Schmelzerhitzung des Materials des dritten Schritts und der Dampfphasenzüchtung des zu züchtenden Materials in der Öffnung (5) in Form eines filamentförmigen Kristalls.

2. Verfahren nach Anspruch 1, dadurch gekennzeichnet, daß der zweite Schritt der Herstellung einer Öffnung (5) durch Abscheidung einer Maske und Angriff des Materials der ersten Schicht (1) durch die Maske durchgeführt wird.

3. Verfahren nach Anspruch 2, dadurch gekennzeichnet, daß der dritte Abscheidungsschritt durch Verdampfung des Materials durchgeführt wird, worauf das Entfernen der Maske und des an der Oberfläche der Maske aufgebrachten Materials folgen.

4. Verfahren nach Anspruch 1, dadurch gekennzeichnet, daß dem ersten Schritt der Herstellung der ersten Schicht (1) eine Phase der Abscheidung einer zweiten Schicht aus einem Material vorausgeht, das einen Bestandteil enthält, in dem sich das Substrat lösen kann, und daß der dritte Abscheidungssschritt durch Verdampfung durchgeführt wird, die es ermöglicht, in der Öffnung (5) nur diesen Bestandteil zu behalten.

5. Verfahren nach Anspruch 1, dadurch gekennzeichnet, daß das Substrat Silicium ist und das beim dritten Schritt abgeschiedene Material ein Metall wie Au, Cu, Pt, Pd, Ni, Gd, Mg ist, und daß der vierte Schritt mit einem Gas aus SiH₄ und HCl oder SiH₂Cl₂ und HCl oder SiCl₄ durchgeführt wird.

6. Verfahren nach Anspruch 1, dadurch gekennzeichnet, daß das Substrat GaAs ist und der vierte Schritt mit einem Gas aus GaCl + As₄ oder TMG, TEG + AsH₃ durchgeführt wird.

7. Verfahren nach Anspruch 6, dadurch gekennzeichnet, daß der dritte Schritt durch Verdampfung des Arsens des GaAs durchgeführt wird, das sich in der Öffnung befindet, so daß ein Galliumtropfen in der Öffnung gebildet wird.

8. Verfahren nach Anspruch 1, dadurch gekennzeichnet, daß eine Temperaturänderung beim vierten Züchtungsschritt vorgesehen wird, um die Breite (den Durchmesser) des filamentförmigen Kristalls zu ändern.

9. Verfahren nach einem der vorhergehenden Ansprüche, dadurch gekennzeichnet, daß das Material des dritten Schritts einen Bestandteil enthält, der bei der Züchtungstemperatur des vierten Schritts flüchtig ist, und daß die Züchtung des vierten Schritts in Gegenwart eines Gases stattfindet, das die Kontrolle der Verdampfung dieses Bestandteils ermöglicht.

10. Verfahren nach einem der vorhergehenden Ansprüche 1 bis 8, dadurch gekennzeichnet, daß die Züchtung eines korrosiven Gases, das den Angriff auf wenigstens einen Bestandteil des beim dritten Schritt aufgebrachten Materials ermöglicht, wobei die Menge dieses korrosiven Gases so kontrolliert wird, daß der Angriff auf diesen Bestandteil kontrolliert ist.

11. Verfahren zur Herstellung einer spitzen Mikrokathode unter Anwendung des Verfahrens eines der vorhergehenden Ansprüche, dadurch gekennzeichnet, daß es vor dem zweiten Herstellungsschritt eine Phase der Herstellung einer dritten Schicht (2) aus einem elektrisch leitenden Material aufweist, auf den eine weitere Phase der Herstellung einer vierten Schicht (3) aus einem dielektrischen Material folgt, das als Passivierungsschicht dient.
